Europäisches Patentamt

European Patent Office

Office européen des brevets

(11) Publication number: 0 372 728
A2

# (12) EUROPEAN PATENT APPLICATION

(21) Application number: 89311686.3

(51) Int. Cl.5: C09J 7/02

(22) Date of filing: 10.11.89

(30) Priority: 07.12.88 US 281085

(43) Date of publication of application:
13.06.90 Bulletin 90/24

(84) Designated Contracting States:
DE FR GB IT

(71) Applicant: MINNESOTA MINING AND
MANUFACTURING COMPANY
3M Center, P.O. Box 33427
Saint Paul, MN 55133- 3427(US)

(72) Inventor: Keller, Janet T. c/o Minnesota
Mining and
Manufacturing Company 2501 Hudson Road
St. Paul Minnesota 55133-3427(US)
Inventor: Mitchell, Sharon N. c/o Minnesota
Mining and
Manufacturing Company 2501 Hudson Road
St. Paul Minnesota 55133-3427(US)

(74) Representative: Baillie, Iain Cameron et al
c/o Ladas & Parry Isartorplatz 5
D-8000 München 2(DE)

(54) Smoothly removable cover tape for electronic component carrier.

(57) Cover tape for a compartmentalized carrier for electronic components. A heat-resistant film (e.g., polyester, polycarbonate, nylon, polystyrene, or PVC) is provided with a heat-sealable but smoothly removable adhesive coating that is a blend of SIS (or other non-crosslinking) block copolymer and an adhesion modifier such as a hydrocarbon resin, oil, or wax.

Fig. 1

EP 0 372 728 A2

# SMOOTHLY REMOVABLE COVER TAPE FOR ELECTRONIC COMPONENT CARRIER

Background of the Invention

This invention relates to compartmentalized carriers for electronic components and is particularly concerned with a removable cover tape for maintaining the components in their respective compartments prior to installation on a printed circuit board (PCB).

With the current trend toward miniaturization of electrical and electronic components and the additional trend toward automation of manufacturing and assembly in the electrical and electronic industries, systems that automatically place small leadless components on printed circuit boards have been developed. These Systems employ so-called "surface mount technology" (SMT) as opposed to systems where the components have leads that are inserted through holes in the circuit boards ("through hole technology," or THT).

Perhaps the most popular way of supplying components for SMT is to place them in open-topped compartments, or pockets, embossed from an elongate strip of thermoplastic film, known as a carrier tape. The components are retained in their respective compartments by means of a transparent or translucent cover tape that is removably adhered to the lateral upper edges of the carrier tape immediately adjacent the compartments. The cover tape is gradually stripped from the carrier tape to expose individual components for robotic placement on circuit boards that have been silk screened with a solder paste. The boards and the electronic components are then passed through an oven to melt the solder and permanently electrically connect the components to the board.

The Electronics Industry Association (EIA) has very stringent standards as to the force required for separating the cover tape from the carrier tape. For example, if the force is too low, it is likely that twisting the carrier tape-cover tape laminate will cause the two to separate, spilling the electronic components. If the force is too high, the robotic equipment employed has difficulty performing its function, and the rate of removal will be irregular. If the cover tape adheres to the "crossbars" (i.e., the narrow portion of the carrier tape that separates the mouths of adjacent compartments), the rate of removal is likely to be erratic and jerky, again causing difficulty with the automatic equipment. When the cover tape is a normally tacky and pressure-sensitive adhesive (PSA) tape (cf., e.g. U.S. Pat. No. 4,298,120), the electronic components may be inadvertently and prematurely removed when the cover tape is stripped from the carrier tape; further, such tapes tend to adhere to the crossbars, again resulting in an erratic rate of removal. U.S. Pat. No. 4,450,959 attempts to cure these problems by applying a strip of silicone-coated paper over the portion of the PSA positioned over the mouths of the compartments, thereby increasing cost.

SCOTCHPAK TM 112 film (a heat-sealable polyester-polyethylene composite of the type disclosed in U.S. Pat. No. 3,188,265, commercially available from Minnesota Mining and Manufacturing Company) has been suggested for use as a heat-sealable cover tape. Unfortunately, however, the polyethylene does not bond well to carrier tapes made from either polyester or polyvinyl chloride, two of the most common polymers employed. Other heat-sealable cover tapes presently in the marketplace tend to increase in adhesion over a period of time, especially under the normal temperatures of transportation and storage (often as high as 65° C.), making them unsatisfactory for reasons previously discussed. If an adhesive heat seals at too low a temperature, an unstable bond may be created so that storage under normal conditions may cause the seal to fail, while if it heat seals at too high a temperature, the carrier tape, which is normally formed from a thermoplastic resin, may be damaged. The adhesive in still other cover tapes tends to fail cohesively and thus leave a residue on the carrier tape, not only a potential source of contamination for the electronic components and assembly hardware but also rendering the carrier tape non-resealable. Ideally, the cover tape should be sealable to the carrier tape over a wide temperature range, reducing the need to employ precise control of the temperature of the heat sealing equipment.

Another feature of cover tape that is desired but rarely attained is resealability. Some manufacturers of electronic equipment remove the cover tape from the carrier to test certain of the electronic components, after which the components are replaced. For greatest convenience in robotic procedures, it is desirable to be able to reseal the carrier tape with a cover tape.

Summary

The present invention provides a cover tape that has satisfactory adhesion to polyester, PVC, and other thermoplastic carrier tapes (preferably a 180° peel adhesion value of 10-70 grams at a removal rate of 120 mm/minute when tested in accordance with the procedure specified in Section 3.9 of EIA Standard 481, Revision A, and less than 100 grams, even after being aged for 2 weeks at 60° C.) and is flexible enough that the carrier tape-cover tape composite can be twisted without separating. The cover tape of the invention, which has a consistently smooth and clean peel removal, employs an adhesive that can be heat-sealed at temperatures in the approximate broad range of 140-220° C. and, if desired, the carrier tape can be resealed.

The cover tape of the invention comprises a heat-resistant flexible polymeric film backing (e.g., polyester, polyvinyl chloride, polystyrene, polycarbonate, high melting polyolefins, or nylon) coated with a hot melt adhesive that comprises about 25-75 parts of a non-crosslinking synthetic elastomeric block copolymer (e.g., styrene-isoprene-styrene -- SIS -- or styrene-ethylene-butylene-styrene -- SEBS), correspondingly about 75-25 parts of an adhesion modifier (e.g., low density polyethylene), and preferably up to about 3 parts of an antioxidant (e.g., "Irganox" 565, 1010 or 1076, available from Ciba-Geigy Corporation). Noncrosslinking rubbers do not form gel particles during compounding, and compositions made with them are thus not only easier to process than rubbers that are susceptible to crosslinking but also provide more consistent adhesive properties. Preferred adhesive compositions contain 25-67%, and more preferably 40-60%, of the block copolymer; the amount of adhesion modifier is, correspondingly, 75-33% and 60-40% respectively. Such processing aids as hydrocarbon resins, oils, or waxes may be added, and other materials may be included to minimize static electricity problems.

As used in the preceding paragraph and throughout the remainder of the specification, all parts and percentages are by weight unless otherwise noted.

Brief Description of the Drawing

Understanding of the drawing will be enhanced by referring to the accompanying drawing, in which like numbers refer to like parts in the several views, and in which:

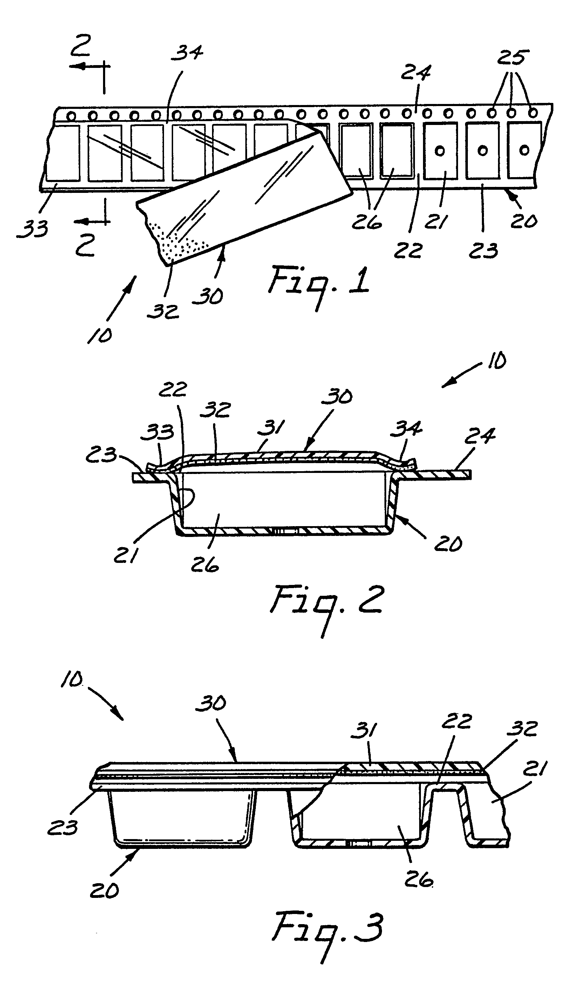

FIG. 1 is a plan view of a carrier tape-cover tape composite containing electronic components, showing the cover tape partially removed;

FIG. 2 is a cross-sectional view of the composite of FIG. 1, taken along section line 2-2, looking in the direction of the arrows; and

FIG. 3 is a longitudinal view of the composite of FIG. 1, and partially in cross-section to facilitate understanding.

Detailed Description

In the drawings, composite tape 10 comprises carrier tape 20 and cover tape 30. Carrier tape 20 is embossed to provide open-topped compartments 21 separated by crossbars 22 and containing electronic components 26. Adjacent the open tops of compartments 21 are lateral narrow flange 23 and wide flange 24, the latter being provided with indexing holes 25 to facilitate handling on automatic equipment. Cover tape 30 comprises heat-resistant flexible backing 31 coated with heat-sealable adhesive 32. Cover tape 30 is heat-sealed to flanges 23 and 24 along narrow lines 33 and 34.

Understanding of the invention will be further enhanced by referring to the following illustrative but nonlimiting examples. As used in the examples, various components are referred to by their trade names, which are understood to represent products as indicated below:

"Kraton" 1107 -- SIS block copolymer having a styrene content of about 14% and a number average molecular weight of about 100,000, commercially available from Shell Chemical Company.

"Kraton" 1111 -- thermoplastic SIS block copolymer, containing 21% styrene, similar to Kraton 1107 but having a higher molecular weight.

"Kraton" 1652 -- linear SEBS block copolymer containing about 29% styrene having a tensile strength of about 31,000 kPa.

"Kraton" 1726 -- linear SEBS block copolymer containing about 30% styrene having a tensile strength of about 2400 kPa.

"Tenite" 1550P -- low molecular weight polyethylene having a density of about 0.918 and a melt temperature in the range of 315-330° C. for extrusion coating, commercially available from Eastman Chemical Products, Inc.

"Irganox" 1010 -- tetrakis [methylene(3,5-di-tert-butyl-4-hydroxycinnamate)] antioxidant, available from Ciba-Geigy Corporation

"Kristalex" 5140 -- low molecular weight hydrocarbon resin, having a ring and ball softening point of about

3

140° C., commercially available from Hercules, Inc.

In each of the examples, the composition shown in Table I below was prepared by compounding the block copolymer elastomer with the adhesion modifier and antioxidant in a twin screw extruder; the mixture was then hot melt coated at a die temperature of about 200° C. onto the polyethylene side of a SCOTCHPAK 246 film (a polyethylene:polyester composite film about 25 micrometers thick, commercially available from Minnesota Mining and Manufacturing Company). The thickness of the hot melt adhesive coating in each case was about 50 micrometers. The polyethylene functioned as a primer for the heat-sealable adhesive, which would not otherwise bond firmly to the polyester film.

TABLE I.

| Hot Melt Adhesive Compositions | | | | | | | |
|---|---|---|---|---|---|---|---|
| | Block Copolymer Elastomer | | | | Adhesion Modifier | Antioxidant | Processing Aid |
| Example | "Kraton" 1107 | "Kraton" 1111 | "Kraton" 1652 | "Kraton" 1726 | "Tenite" 1550P | "Irganox" 1010 | "Kristalex" 5140 |
| 1 | -- | 66 | -- | -- | 33 | 1 | -- |
| 2 | -- | -- | 23 | 23 | 47 | -- | 7 |
| 3 | 25 | -- | -- | -- | 74.8 | 0.2 | -- |
| 4 | 33.3 | -- | -- | -- | 66.4 | 0.3 | -- |
| 5 | 46 | -- | -- | -- | 53 | 1 | -- |
| 6* | 50 | -- | -- | -- | 50 | -- | -- |

* Compounded in single screw extruder

The heat-sealable sheet material of each of Examples 1-6 was then slit to a width of 13.3 mm to form cover tapes. Each such tape was then positioned over a commercially available carrier tape (3M Brand No. 3000), with the coated heat side of the cover tape confronting the open side of the carrier tape. A heat sealing machine (Systemation MT-30, commercially available from Systemation Engineered Products, Inc.), was then employed to seal a 0.51-mm strip along each edge for a total width of 1.02 mm, employing a pressure of about 140 kPa and a sealing temperature of 140-220° C.

Each of the heat-sealed composites was then subjected to the EIA standard peel removal test previously described, noting the low, high and average values. Results are shown in TABLE II. Performance of a control sample, made using a presently commercial prior art cover tape (3M Brand YR-265, a polyester film having an ethylene-vinyl acetate heat seal coating), also reported. The ends of a 30-cm length of composite were then manually twisted 90° to see if there was any evidence of delamination.

4

TABLE II

| Peel Removal Force for Examples 1-6, Grams per 1.02 mm Sealed Width | | | | | |
|---|---|---|---|---|---|
| | Sealing Temperature, °C | | | | Twist Test |
| Example | | High | Low | Average | |
| 1* | 140 | 49 | 17 | 38 | fail |
| 1* | 150 | 57 | 22 | 42 | fail |
| 1* | 160 | 50 | 20 | 34 | pass |
| 1* | 170 | 60 | 24 | 38 | pass |
| 1* | 180 | 68 | 25 | 41 | pass |
| 1* | 190 | 79 | 21 | 45 | pass |
| 1* | 200 | 84 | 22 | 50 | pass |
| 1* | 210 | 95 | 28 | 60 | pass |
| 2 | 160 | 110 | 40 | 8 | not tested |
| 3 | 200 | 35 | 4 | 20 | not tested |
| 4 | 200 | 58 | 10 | 33 | not tested |
| 4 | 220 | 58 | 7 | 31 | not tested |
| 5 | 140 | 46 | 9 | 25 | pass |
| 5 | 160 | 50 | 23 | 33 | pass |
| 5 | 180 | 49 | 25 | 39 | pass |
| 5 | 200 | 80 | 30 | 57 | pass |
| 6 | 140 | 65 | 18 | 46 | fail |
| 6 | 160 | 65 | 18 | 36 | pass |
| 6 | 180 | 47 | 15 | 32 | pass |
| 6 | 200 | 63 | 29 | 51 | pass |
| Control | 100 | 10 | 7 | 4 | fail |
| Control | 120 | 36 | 20 | 8 | fail |
| Control | 140 | 62 | 44 | 21 | pass |
| Control | 160 | 82 | 38 | 67 | pass |
| Control | 180 | 90 | 61 | 80 | pass |
| Control | 200 | 100 | 70 | 91 | pass |

* Example 1 was heat sealed at a pressure of 210 kPa.

Examples 3, 4, and 5 of TABLE II show that the peel removal force can be adjusted by varying the amount of adhesion modifier ("Tenite" 1550P). TABLE II also shows that the cover tape of the present invention can be acceptably heat sealed over a broad range of temperatures from about 140° C. to about 210° C., whereas a currently available product has a limited range of sealing temperatures.

Selected carrier tape-cover tape composites from Example 5 and the control were heat aged at 60° C. according to the procedure described above and peel removal force again determined; results are given in TABLE III. The sealing temperature used was a mid-range temperature considered optimal for each construction. Example 5 was heat sealed at 160° C. and the control was heat sealed at 140° C. A lower sealing temperature was used for the control because, as is shown in TABLE II, the peel removal force for heat sealing at 160° C. was near the upper limits for acceptability.

TABLE III

| Peel Removal Force After Aging, Grams per 1.02 cm Sealed Width | | | | | | |
|---|---|---|---|---|---|---|
| Time at 60°C., hours | Example 5 | | | Control | | |
| | High | Low | Average | High | Low | Average |
| 0 | 50 | 23 | 33 | 55 | 20 | 39 |
| 24 | 44 | 39 | 30 | 200 + | 72 | 84 |
| 168 | 58 | 42 | 49 | 200 + | 79 | 99 |
| 336 | 52 | 20 | 40 | 200 + | 78 | 96 |
| 504 | 50 | 25 | 39 | 200 + | 83 | 105 |

As can be seen from TABLE III, in contrast to the prior art control cover tape, the cover tape of the invention does not increase in adhesion after heat aging and is well within the EIA specification for peel removal force.

Many different carrier tapes can be employed in combination with the cover tapes of the invention. Good results have been obtained with carrier tapes made of polyester PVC, polycarbonate, and polystyrene, and it is believed that numerous other polymers could also be employed.

The peel adhesion figures recited in TABLES II and III are based on a total heat-sealed width of 1.02 mm. It will, of course, be appreciated that, to ensure that peel adhesion does not exceed 100 grams, a greater heat sealing width may require reducing the adhesion per heat-sealed width, e.g., by modifying the sealing process parameters.

## Claims

1. A heat-sealable cover tape for use with embossed compartmentalized carrier tapes of the type used to transport surface mountable electronic components, said cover tape comprising in combination: a heat-resistant flexible polymeric film backing coated with a hot melt adhesive that comprises about 25-75 parts of a non-crosslinking synthetic elastomeric block copolymer and correspondingly about 75-25 parts of an adhesion modifier, said cover tape, upon being heat-sealed to a carrier tape to form a composite, resisting separation when the composite is twisted and being smoothly and cleanly removable, even after being aged for two weeks at 60° C., at a force not in excess of 100 grams.

2. The cover tape of claim 1 wherein the adhesive comprises about 40-60% block copolymer and correspondingly about 60-40% adhesion modifier.

3. The cover tape of claim 1, wherein the adhesive contains an effective amount of an antioxidant, thereby permitting composites to be exposed to aging at elevated temperatures without being deleteriously affected.

4. The cover tape of claim 3 whereing the block copolymer is a styrene-isoprene-styrene synthetic rubber or a styrene-ethylene-butylene styrene synthetic rubber.

5. The cover tape of claim 4 wherein the adhesion modifier is a hydrocarbon resin, oil, or wax.

6. The cover tape of claim 5 wherein the backing is a polyester-polyethylene composite film, the adhesive being coated over the polyethylene surface.

7. The cover tape of claim 6 wherein the peel adhesion of a carrier tape-cover tape composite is in the approximate range of 10-70 grams.

Fig. 1

Fig. 2

Fig. 3